Europäisches Patentamt

European Patent Office

Office européen des brevets

(11) Veröffentlichungsnummer: **0 132 752**
**B1**

(12) EUROPÄISCHE PATENTSCHRIFT

(45) Veröffentlichungstag der Patentschrift: 09.01.91

(51) Int. Cl.⁵: **H 03 D 3/00, H 04 B 1/10**

(21) Anmeldenummer: **84108374.4**

(22) Anmeldetag: **17.07.84**

(54) Detektor zur Anzeige von Frequenzstörhubspitzen.

(30) Priorität: 20.07.83 DE 3326062

(43) Veröffentlichungstag der Anmeldung:
13.02.85 Patentblatt 85/07

(45) Bekanntmachung des Hinweises auf die
Patenterteilung:
09.01.91 Patentblatt 91/02

(84) Benannte Vertragsstaaten:
DE FR GB IT NL SE

(56) Entgegenhaltungen:
EP-A-0 075 647     US-A-3 979 679
FR-A-2 272 541     US-A-4 112 371
GB-A-2 034 142     US-A-4 156 202
US-A-3 613 012

ELECTRIC COMPOUNDS & APPLICATIONS,
Band 2, Nr. 4, August 1980, Seiten 215-218,
Eindhoven, NL; D.J. VAN DER WAL:
"Interference suppression for FM radios"
"UKW-Berichte", 14 Jahrgang, Heft 4/1974,
Seiten 230-241

(73) Patentinhaber: Hans Kolbe & Co.
Bodenburger Strasse 32
D-3202 Bad Salzdetfurth (DE)
(73) Patentinhaber: N.V. Philips'
Gloeilampenfabrieken
Groenewoudseweg 1
NL-5621 BA Eindhoven (NL)

(72) Erfinder: Lindenmeier, Heinz, Prof. Dr. Ing.
Fürstenrieder Strasse 7
D-8033 Planegg (DE)
Erfinder: Manner, Ernst, Dipl.-Ing.
Rembrandstrasse 6
D-8012 Ottobrunn (DE)
Erfinder: Flachenecker, Gerhard, Prof. Dr. Ing.
Bozener Strasse 2
D-8012 Ottobrunn (DE)

(74) Vertreter: De Jongh, Cornelis Dominicus et al
INTERNATIONAAL OCTROOIBUREAU B.V. Prof.
Holstlaan 6
NL-5656 AA Eindhoven (NL)

Courier Press, Leamington Spa, England.

**Beschreibung**

Die Erfindung betrifft einen Detektor zur Anzeige von Mehrwegeempfangsstörungen durch Demodulation des Zwischenfrequenzssignals in einem UKW-Rundfunkempfangsgerät mit einem Frequenzdemodulator, dessen Ausgangssignal einer Auswerteschaltung zugeführt ist, an deren Ausgang die Anwesenheit einer Mehrwegeempfangsstörung durch ein logisches Signal angezeigt ist.

Solche Detektoren werden vorzugsweise zur Verbesserung des Rundfunkempfangs in Kraftfahrzeugen verwendet. Der Detektor hat die Aufgabe, eine Empfangsstörung zu erkennen und anzuzeigen. Daraufhin wird eine Umschaltung eingeleitet, die im allgemeinen elektronisch durchgeführt wird. Zum Beispiel wird in der DE—A—31 07 970 ein FM-Empfänger beschrieben, in dem mit Hilfe eines Detektors und einer Umschalteinrichtung automatisch das Mehrwegerauschen vermieden wird. In der DE—A—31 22 057 A1 wird eine Tunersteuerung mit einem Detektor zum Wahrnehmen des Signalpegels in einem Rundfunkempfänger vorgeschlagen. Weiterhin ist in der US—A—3.825.697 von einer Umschalteinrichtung die Rede, die nach Erkennung einer Störung infolge des Mehrwegeempfangs von Stereo-Betrieb auf Monobetrieb umschaltet. In allen beschriebenen Fällen ist ein Detektor zur Erkennung der Störung erforderlich.

Ein Detektor zur Erkennung von Störungen ist aus der US—A—4.216.353 bekannt. Dieser Detektor ist speziell konzipiert für die Erkennung von störender Mehrwegeausbreitung der elektromagnetischen Wellen mit großen unterschiedlichen Laufzeiten. Aus diesem Effekt resultieren am Ausgang des Frequenzdemodulators ein erhöhtes Rauschen und eine Verzerrung der niederfrequenten Nachricht. Im Fall der Stereo-Aussendung führt dieser Effekt auch zu einem erhöhten Übersprechen zwischen den beiden Stereo-Kanälen. Der in dieser Patentschrift beschriebene Detektor beruht auf der Auswertung des Amplituden-Zeitverlaufs des empfangsseitig vorliegenden frequenzmodulierten Signals. Dieser Detektor hat insbesondere in Hinblick auf einen Einsatz in einem Autoempfänger folgende Nachteile:

Es ist bekannt, daß die Überlagerung von Teilwellen am Empfangsort bei Laufzeitunterschieden zwischen einer µs und 100 µs zu nennenswerten Verzerrungen der niederfrequenten Nachricht am Ausgang des FM-Demodulators führt. Diese Verzerrung geht einher mit einer vom niederfrequenten Nachrichteninhalt abhängigen Amplitudenmodulation des resultierenden Hochfrequenzträgers am Empfangsort. Der in der US—A—4.216.353 angegebene Detektor erkennt diese Amplitudenmodulation und zeigt sie als Störung an. Meistens jedoch ist das Wellenfeld aus Teilwellen zusammengesetzt, deren Laufzeitunterschiede unter einer µs liegen. Diese Überlagerung der Teilwellen führt empfängerseitig nicht zu Störungen, verursacht aber eine starke Ortsabhängigkeit der resultierenden Feldamplitude.

Der Eingangspegel des Autoempfängers erfährt deshalb durch die Eigenbewegung des Fahrzeugs in diesem Wellenfeld eine zeitliche Amplitudenänderung, die sich als Amplitudenmodulation ausdrückt. Der angegebene Detektor besitzt deshalb den Nachteil, zwischen einer Amplitudenmodulationsart, die nicht zu Störungen führt, und einer anderen Amplitudenmodulationsart, die auf Grund der Mehrwegeausbreitung mit großen Laufzeitunterschieden entsteht und deshalb Störungen hervorruft, unterscheiden zu müssen. Besonders schwierig ist die Situation dadurch, daß beide Modulationsarten statistisch und zeitweise gleichzeitig auftreten. Daraus resultiert eine unsichere Erkennung der wirklichen Störung und eine verhältnismäßig große Detektionszeit. Diese Detektionszeit führt dazu, daß die Eingriffe in das Empfangssystem durch Umschalten erst so spät vorgenommen werden können, daß der Rundfunkhörer die Störung bereits wahrgenommen hat.

Aufgabe der Erfindung ist es deshalb, das Vorliegen von Empfangsstörungen, die beim UKW-Stereo- oder Monoempfang auftreten und insbesondere von Mehrwegeempfang mit starken Laufzeitunterschieden der überlagerten Wellen herrühren, schnell und treffsicher zu erkennen und anzuzeigen.

Die Aufgabe wird erfindungsgemäss dadurch gelöst, dass die Demodulationskennlinie des Frequenzdemodulators so gestaltet ist, dass der Aussteuerbereich, innerhalb dessen das Demodulatorausgangssignal mit steigender Frequenzabweichung von der Trägerfrequenz (Zwischenfrequenzsignal) steigt, nennenswert grösser ist als der maximale Frequenzhub des mit dem Basisbandsignal in der Frequenz modulierten Zwischenfrequenzträgers, und dass die Anwesenheit einer Mehrwegeempfangsstörung in der Auswerteschaltung detektiert und durch ein logisches Signal angezeigt wird, wenn das Demodulatorausgangssignal eine geeignet vorgegebene Frequenzstörhubschwelle überschreitet.

Der erfindungsgemässe Detektor benutzt also ausschliesslich die Störhubpulse als Kriterium für das Vorhandensein einer Störung. Im Falle einer Diversity-Anlage wird durch Umschaltung ein anderes Signal ausgewählt, das weniger Verzerrungen und als Kriterium keine Frequenzstörhubimpulse besitzt.

Es wird bemerkt, dass aus dem Dokument "UKW-Berichte", 14. Jahrgang, 4 Quartal, Heft 4/1974, Seiten 230—241, J. Kästler: "FM-Rundfunkempfänger mit Rasteroszillator" eine Demodulationskennlinie des Frequenzdemodulators gemäss dem kennzeichnenden Teil des Anspruchs 1 an und für sich bekannt ist, aber dass diesem Dokument nicht zu entnehmen ist, dass mit einer linearen Demodulationskennlinie des Frequenzdemodulators Mehrwegeempfangsstörungen detektiert werden können.

Weiter wird bemerkt, dass in der EP—A—0 075 647 ein FM-Demodulator beschrieben ist, mit einer derartigen Demodulationskennlinie, dass sich an seinem Ausgang auch Frequenzstörhubpulse ergeben können. Weiterhin wird in dieser Patentanmeldung eine Auswerteschaltung zur Erkennung von Störungen mit Hilfe eines selektiven Filters beschrieben. Im Gegensatz zum erfindungsgemässen Detektor bewirkt das selektive Filter mit seiner bandbegrenzenden Wirkung, dass auf keinerlei Weise am Ausgang dieses Filters Frequenzstörhubspitzen auftreten können, da es sich um ein selektives Filter mit einer relativ geringen Bandbreite handelt. Das Signal am Ausgang dieses Filter kann somit nicht sinnvoll einer Auswerteschaltung zugeführt werden, an deren Ausgang das Ueberschreiten einer geeignet vorgegebenen Frequenzstörhubschwelle angezeigt werden muss. Für die praktische Anwendung hat die in der EP—A—0 075 647 beschriebene Auswerteschaltung nämlich den entscheidenden Nachteil, dass aufgrund der bandbegrenzenden Wirkung des Filters das Auswertungssignal der zeitlichen Aenderung des Frequenzstörhubs im Empfangssignal nicht folgen kann und deshalb die Störung nicht schnell und treffsicher erkannt und angezeigt werden kann, wie gemäss der Aufgabenstellung vorliegender Erfindung erfordert wird.

Weitere vorteilhafte Ausführungsformen der Erfindung sind in den Unteransprüchen gekennzeichnet.

Die Erfindung wird anhand von Ausführungsbeispielen in der Zeichnung näher erläutert. Dabei sind die Schaltungen in Blockschaltbildern wiedergegeben. Es zeigen:

Fig. 1 einen Detektor nach der Erfindung;

Fig. 2 die Demodulationskennlinie 25 des breitbandig arbeitenden (FM-) Frequenzdemodulators mit dem durch 26 angegebenen Aussteuerbereich; .

Fig. 3 den Frequenzhub mit Störfrequenzspitzen eines durch Mehrwegeausbreitung gestörten Signals (großer Laufzeitunterschied);

Fig. 4 eine Ausführungsform eines Detektors nach der Efindung mit einer die Steilheit der Pulsflanken anhebenden Schaltung 5.

Fig. 5 eine Ausführungsform der die Steilheit der Pulsflanken anhebenden Schaltung (Differenzierglied 6);

Fig. 6 eine Kettenschaltung von Differenziergliedern gemäß Fig. 5 als weitere Ausführungsform der Schaltung 5 zur Anhebung der Steilheit der Pulsflanken;

Fig. 7 eine Ausführungsform eines Detektors nach der Erfindung mit einer die Steilheit der Pulsflanken anhebenden Schaltung gemäß einer geraden Potenzfunktion 8 und mit einem unipolaren Pegeldiskriminator 7 und einer Logikschaltung 4;

Fig. 8 eine Ausführungsform eines Detektors nach der Erfindung mit einer die Steilheit der Pulsflanken anhebenden Schaltung gemäß einer Hyperbel-Cosinusfunktion 9 und mit einem unipolaren Pegeldiskriminator 7 und einer Logikschaltung 4;

Fig. 9 eine die Steilheit der Pulsflanken anhebende Schaltung 8 (geradzahlige Potenzfunktion).

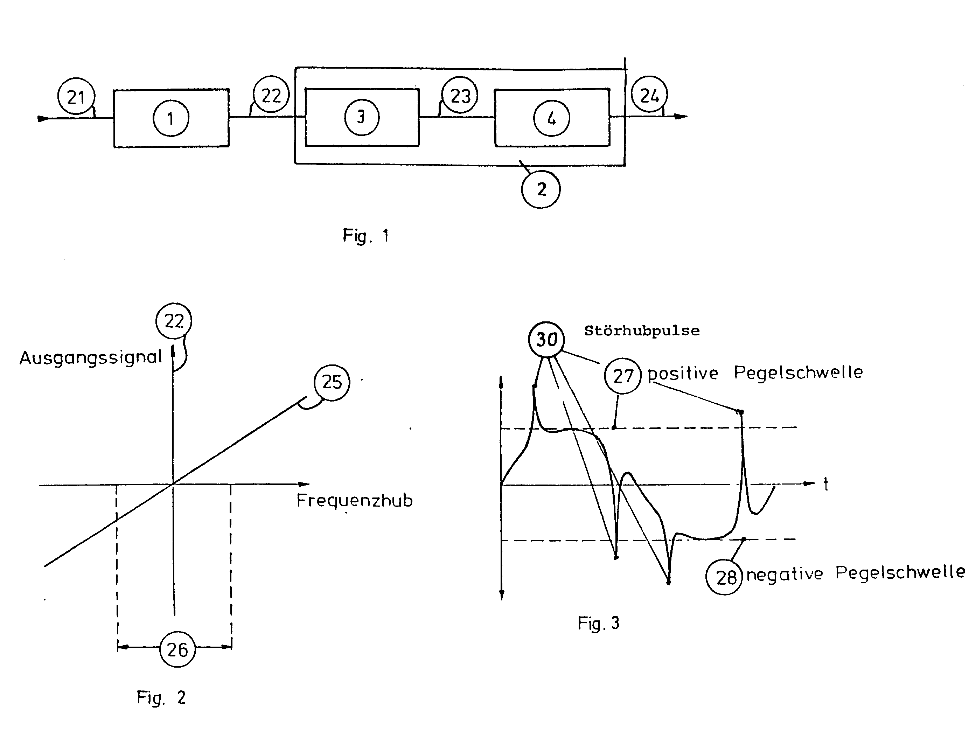

Fig. 1 zeigt einen Detektor nach der Erfindung.

In Fig. 3 ist der Frequenzhub eines empfangenen Signals dargestellt, das aus zwei überlagerten Teilwellen mit großem Laufzeitunterschied gebildet ist. Durch den Modulationsinhalt der frequenzmodulierten Teilwellen entstehen Frequenzstörhubspitzen oder -pulse 30, wie sie in Fig. 3 dargestellt sind. 27 bezeichnet die positive Pegelschwelle, 28 die negative Pegelschwelle. Die Frequenzstörhubspitzen 30 werden nach dem Grundgedanken der vorliegenden Erfindung mit Hilfe eines breitbandig arbeitenden (FM-) Frequenzdemodulators 1 detektiert. In der Regel wird die Bandbreite des FM-Demodulators 1, der meist als Ratio-Detektor ausgeführt ist, nur so groß gewählt, daß der lineare Demodulationsbereich lediglich die Bandbreite gemäß dem maximal im Basissignal auftretenden Frequenzhub umfaßt. Dem FM-Demodulator 1 wird das Zwischenfrequenzsignal 21 zugeführt, und er gibt das Ausgangssignal 22 ab.

Ein derartiger schmalbandiger Frequenzdemodulator ist nicht in der Lage, die Spitzen des Frequenzstörhubs, wie sie beispielhaft bei 30 in Fig. 3 dargestellt sind, auszuwerten. Der üblich verwendete Ratio-Detektor beschneidet diese Spitzen, so daß an seinem Ausgang lediglich verzerrte Signalinhalte, die innerhalb des Frequenzbereichs des Basisbandes liegen, erscheinen und den Signalinhalt verzerren. Diese Verzerrungen im Basisband stören zwar den Empfang, können jedoch nicht vom gewünschten Nachrichteninhalt durch technische Mittel herausgefiltert werden. Die vorliegende Erfindung basiert auf einer breitbandigen Detektion derart, daß die Frequenzstörhubspitzen sich voll am Ausgang 22 des FM-Demodulators 1 als Störsignalspitzen ausbilden und mit einer nachfolgenden Auswerteschaltung 2 angezeigt werden. Vorzugsweise besitzt deshalb der Frequenzdemodulator des Detektors eine Bandbreite, die der Kanalbandbreite des Zwischenfrequenzkanals entspricht, und eine Aussteuerkennlinie, deren Aussteuerbereich, innerhalb dessen das Ausgangssignal mit steigender Frequenzabweichung von der Trägerfrequenz steigt, sich über die gesamte Bandbreite des Zwischenfrequenzkanals erstreckt. Es est ersichtlich, daß auch bei kleineren Bandbreiten und Aussteuerbereichen von Frequenzdemodulatoren eine Detektion der Frequenzstörhubspitzen grundsätzlich möglich ist. Auf jeden Fall ist es jedoch erforderlich, den Aussteuerbereich eines derartigen Demodulators nennenswert größer zu wählen als es dem maximalen Nutzhub des Basisbandsignals entspricht. Das Ausgangssignal 22 des FM-Demodulators 1 wird der Auswerteschaltung 2 zugeführt. In der Auswerteschaltung 2 werden die Spitzen mit Hilfe eines unipolar bzw. bipolar arbeitenden Pegeldiskriminators 7 bzw. 3 vom Nutzsignal, dessen maximaler Frequenzhub bekannt ist, abgetrennt. Die Schwelle des Pegeldiskriminators wird hierfür geeignet eingestellt und kann in einer besondern Ausführungsform der Erfindung abhängig vom zeitlich mittleren Frequenzhub eingestellt weden. Bei Überschreitung der eingestellten Pegelschwelle liegt eine Frequenzstörhubspitze vor. Das Ausgangssignal 23 des Pegeldiskriminators 3 wird einer binär arbeitenden Logikschaltung 4 zugeführt, an derem Ausgang mit Hilfe eines Binärsignals 24 das Vorliegen einer Empfangsstörung angezeigt wird. Frequenzstörhubspitzen haben in der Regel positive oder negative Polarität. In einer vorteilhaften Ausgestaltung der Erfindung werden sowohl die positiven als auch die negativen Frequenzstörhubspitzen ausgewertet. Hierzu ist es notwendig einen bipolaren Pegeldiskriminator 3 mit einer positiven und einer negativen Pegelschwelle zur Anzeige der Überschreitung eines zulässigen Frequenzstörhubs einzusetzen.

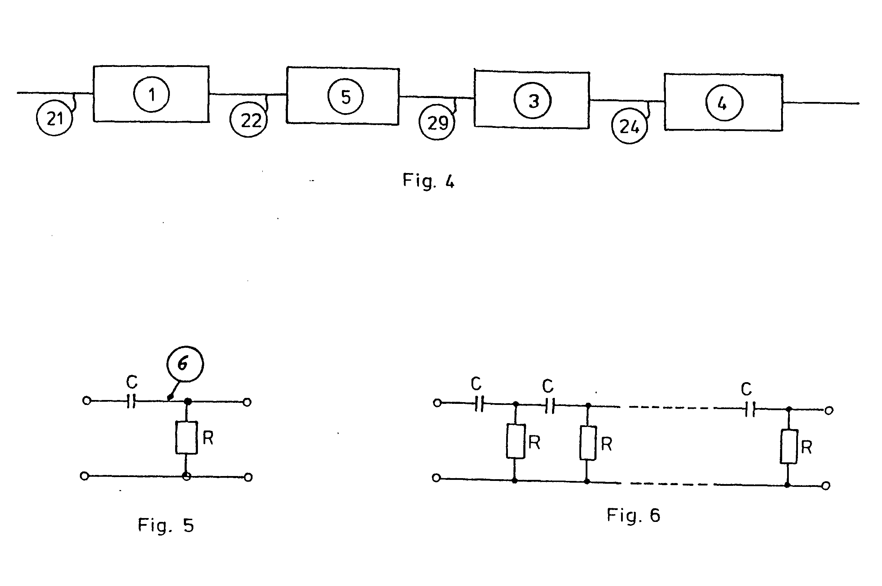

Im Interesse einer sicheren Erkennung der Frequenzstörhubspitzen und somit der durch Mehrwegeempfang bedingten Störung, werden in einer vorteilhaften Ausgestaltung der Erfindung diese Spitzen mit Hilfe einer die Steilheit der Pulsflanken anhebenden Schaltung 5 gemäß Fig. 4 angehoben, der aus Ausgangssignal 22 des FM-Demodulators 1 zugeführt wird und die das verformte Ausgangssignal 29 abgibt. Die Störspitzen heben sich damit noch mehr vom Nutzsignal ab und können vom Pegeldiskriminator 3 mit größerer Sicherheit angezeigt werden. In einer vorteilhaften Ausgestaltung der Erfindung besteht diese die Steilheit der Pulsflanken anhebende Schaltung 5 aus einem C—R-Differenzierglied 6, wie es in Fig. 5 dargestellt ist. Eine Kette derartiger Differenzierglieder 6 gemäß Fig. 6 erlaubt eine weitere Anhebung der Frequenzstörhubspitzen und somit eine Anhebung der Sicherheit der Störungserkennung.

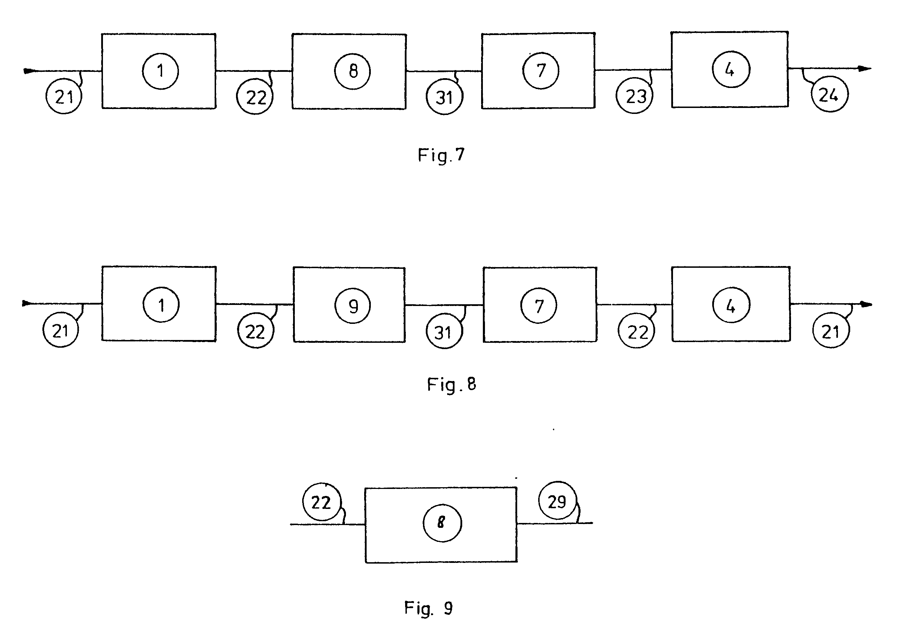

Die Schaltung zur Anhebung der Steilheit der Pulsflanken kann auf an sich bekannte Weise durch Dioden- und Transistorschaltungen gewonnen werden, so daß bezüglich des Zusammenhangs zwischen Ausgangssignal 29 und Eingangssignal 22 eine Potenzfunktion entsteht. Die Exponentialfunktion des Strom-Spannungszusammenhangs einer Halbleiterdiode bzw. der Basis-Emitterdiode eines Transistors kann auf bekannte Weise hierzu genutzt werden. In einer besonderen Ausführungsform der Erfindung ist diese Potenzfunktion bei 8 bezüglich des Zusammenhangs zwischen Ausgangs- und Eingangssignal eine gerade Funktion. In diesem Fall liegen am Ausgang 31 dieser Schaltung 8 Störspitzen mit gleicher Polarität vor. Der hierfür notwendige Pegeldiskriminator 7 arbeitet unipolar. In einer besonderen Ausführungsform der Erfindung ist die die Steilheit der Pulsflanken anhebende Schaltung 8 derart gestaltet, daß bezüglich des Zusammenhangs zwischen Ausgangssignal 31 und Eingangssignal 22 aus einer Funktion mit dem Charakter einer Hyperbel-Cosinusfunktion 9 besteht (Fig. 8). Eine Schaltung mit derartigem Charakter kann vorteilhaft aus zwei antiparallel angesteuerten Bipolartransistoren auf an sich bekannte Weise aufgebaut werden. Ebenso kann die Schaltung aus antiparallelen Halbleiterdioden bestehen. 29 bezeichnet das verformte Signal als Ausgangssignal der die Steilheit der Pulsflanken anhebenden Schaltung 31 das verformte Signal in Form von Ausgangspunkten gleicher Polarität.

In Empfangsgebieten mit kleiner mittlerer Hochfrequenzamplitude ist der Empfang vielfach durch Rauschen gestört. Dieses Rauschen führt zu relativ großen Frequenzstörhüben. Der vorliegende Detektor erkennt neben den Frequenzstörhubspitzen, die durch zeitlich verzögerten Mehrwegeempfang zustande kommen, auch Rauschstörungen. In einer besonderen Ausführungsform der Erfindung werden, um Fehlindikationen zu vermeiden, die Pegelschwellen im Pegeldiskriminator abhängig von der zeitlich gemittelten Trägeramplitude am Empfangsort dynamisch eingestellt. Bei zu kleinen Empfangspegeln wird hierzu die Pegelschwelle im Pegeldiskriminator angehoben.

**Patentansprüche**

1. Detektor zur Anzeige von Mehrwegeempfangsstörungen durch Demodulation des Zwischenfrequenzssignals (21) in einem UKW-Rundfunkempfangsgerät mit einem Frequenzdemodulator (1), dessen Ausgangssignal einer Auswerteschaltung (2) zugeführt ist, an deren Ausgang die Anwesenheit einer Mehrwegeempfangsstörung durch ein logisches Signal angezeigt ist, dadurch gekennzeichnet, dass die Demodulationskennlinie (25) des Frequenzdemodulators so gestaltet ist, dass der Aussteuerbereich (26), innerhalb dessen das Demodulatorausgangssignal (22) mit steigender Frequenzabweichung von der Trägerfrequenz (Zwischenfrequenzsignal) (21)) steigt, nennenswert grösser ist als der maximale Frequenzhub des mit dem Basisbandsignal in der Frequenz modulierten Zwischenfrequenzträger, und dass die Anwesenheit einer Mehrwegeempfangsstörung in der Auswerteschaltung detektiert und durch ein logisches Signal angezeigt wird, wenn das Demodulatorausgangssignal eine geeignet vorgegebene Frequenzstörhubschwelle überschreitet.

2. Detektor nach Anspruch 1, dadurch gekennzeichnet, daß die Auswerteschaltung (2) aus einem unipolar oder bipolar arbeitenden Pegeldiskriminator (3) und einer Logikschaltung (4) besteht und eine Pegelschwelle besitzt und diese Pegelschwelle zur Anzeige der Überschreitung eines vorgegebenen Frequenzstörhubes geeignet eingestellt ist und das Ausgangssignal (23) des Pegeldiskriminators (3) der Logikschaltung (4) zugeführt und an derem Ausgang das Vorliegen der Empfangsstörung durch ein binäres Signal (24) angezeigt ist.

3. Detektor nach Anspruch 2, dadurch gekennzeichnet, daß die Auswerteschaltung (2) an ihrem Eingang eine die Steilheit der Pulsflanken anhebende Schaltung (5) enthält und dessen verformtes Ausgangssignal (29) dem Pegeldiskriminator (3) mit der nachgeschalteten Logikschaltung (4) zugeführt ist.

4. Detektor nach Anspruch 3, dadurch gekennzeichnet, daß die die Steilheit der Pulsflanken anhebende Schaltung (5) durch ein Differenzierglied (6), bestehend aus einer Serienkapazität C und einem Parallelwiderstand R, gebildet ist und die Zeitkonstante R*C so eingestellt ist, daß eine sichere Trennung der zeitlich kurzen Störhubpulse (30) von den zeitlich längeren Nutzhubpulsen erfolgt.

5. Detektor nach Anspruch 4, dadurch gekennzeichnet, daß die die Steilheit der Pulsflanken anhebende Schaltung (5) aus mehreren in Kette geschalteten Differenziergliedern besteht.

6. Detektor nach den Ansprüchen 1 bis 5, dadurch gekennzeichnet, daß die Auswerteschaltung (2) aus einem unipolar arbeitenden Pegeldiskriminator (7) und einer Logikschaltung (4) besteht und der Pegeldiskriminator nur eine Pegelschwelle besitzt und diese Pegelschwelle zur Anzeige der Überschreitung eines vorgegebenen positiven und negativen Frequenzstörhubs geeignet eingestellt ist und das Ausgangssignal (23) des Pegeldiskriminators der Logikschaltung (4) zugeführt ist, an derem Ausgang das Vorliegen der Empfangsstörung durch ein binäres Signal (24) angezeigt ist.

7. Detektor nach Anspruch 6, dadurch gekennzeichnet, daß die Auswerteschaltung an ihrem Eingang eine die Steilheit der Pulsflanken anhebende Schaltung (5) enthält und diese Schaltung Eingangsimpulse mit unterschiedlicher Polarität in Ausgangsimpulse mit gleicher Polarität umwandelt und das so verformte Signal (31) dem Pegeldiskriminator (7) mit der nachgeschalteten Logikschaltung (4) zugeführt ist.

8. Detektor nach den Ansprüchen 6 und 7, dadurch gekennzeichnet, daß die die Steilheit des Pulsflanken anhebende Schaltung (5) bezüglich des Zusammenhangs zwischen Ausgangs- und Eingangssignals aus einer Potenzfunktion (8) mit geradzahligem Exponenten oder aus einer Summe solcher Potenzfunktionen mit gleichen Vorzeichen besteht und der Exponent größer ist als die Zahl 1.

9. Detektor nach den Ansprüchen 6 bis 8, dadurch gekennzeichnet, daß die die Steilheit der Pulsflanken anhebende Schaltung (5) bezüglich des Zusammenhangs zwischen Ausgangs- und Eingangssignals (31 bzw. 22) aus einer Funktion mit dem Charakter einer Hyperbel-Cosinusfunktion (9) besteht.

10. Detektor nach den Ansprüchen 1 bis 5, dadurch gekennzeichnet, daß die Auswerteschaltung (2) aus einem bipolar arbeitenden Pegeldiskriminator (3) und einer Logikschaltung (4) besteht und der Pegeldiskriminator eine positive (27) und eine negative (28) Pegelschwelle besitzt und diese Pegelschwellen zur Anzeige der Überschreitung eines vorgegebenen positiven und negativen Frequenzstörhubes geeignet eingestellt sind und das Ausgangssignal (23) des Pegeldiskriminators der Logikschaltung (4) zugeführt und an derem Ausgang das Vorliegen der Empfangsstörung durch ein binäres Signal (24) angezeigt ist.

11. Detektor nach den Ansprüchen 1 bis 10, dadurch gekennzeichnet, daß die Pegelschwelle des Pegeldiskriminators oder der Pegeldiskriminatoren abhängig von der zeitlich gemittelten Trägeramplitude geeignet eingestellt ist.

12. Detektor nach Anspruch 11, dadurch gekennzeichnet, daß mit abnehmender Träge-ramplitude die Pegelschwelle angehoben ist.

13. Detektor nach den Ansprüchen 1 bis 12, dadurch gekennzeichnet, daß die Pegelschwelle des Pegeldiskriminators oder der Pegeldiskrimi-natoren abhängig vom zeitlich gemittelten Fre-quenzhub dynamisch eingestellt ist.

**Revendications**

1. Détecteur pour indiquer des perturbations dans la réception multivoie, par démodulation du signal de fréquence intermédiaire (21) dans un appareil récepteur radio FM comportant un démodulateur de fréquence (1) dont le signal de sortie est appliqué à un circuit d'évaluation (2), à la sortie duquel la présence d'une perturbation dans la réception multivoie est indiquée par un signal logique, caractérisé en ce que la caractéristique de démodulation (25) du démodulateur de fréquence est telle que le domaine de réglage (26) dans les limites duquel le signal de sortie (22) du démodulateur augmente à mesure qu'augmente l'écart de fréquence par rapport à la fréquence porteuse [signal de fréquence intermédiaire 21)], est nettement plus grand que l'excursion de fréquence maximale de la porteuse de fréquence intermédiaire modulée en fréquence par le signal en bande de base, et que la présence d'une perturbation de réception multivoie est détectée dans le circuit d'évaluation et est indiquée par un signal logique lorsque le signal de sortie du démodulateur excède un seuil d'excursion de fréquence parasite prédéfini de manière adéquate.

2. Détecteur suivant la revendication 1, caractérisé en ce que le circuit d'évaluation (2) est formé d'un discriminateur de niveau (3) à fonctionnement unipolaire ou bipolaire et d'un circuit logique (4) et présente un seuil de niveau et ce seuil de niveau est adéquatement réglé pour indiquer le dépassement d'une excursion de fréquence parasite, et le signal de sortie (23) du discriminateur de niveau (3) est appliqué au circuit logique (4) à la sortie duquel la présence de la perturbation de réception est indiquée par un signal binaire (24).

3. Détecteur suivant la revendication 2, caractérisé en ce que le circuit d'évaluation (2) contient à son entrée un circuit (5) accroissant la raideur des flancs d'impulsions, dont le signal de sortie déformé (29) est appliqué au discriminateur de niveau (3) suivi du circuit logique (4).

4. Détecteur suivant la revendication 3, caractérisé en ce que le circuit (5) accroissant la raideur des flancs d'impulsions est formé par un élément différentiateur (6) constitué d'une capacité série C et d'une résistance parallèle R et la constante de temps R*C est réglée pour conduire à une séparation sûre des impulsions d'excursion parasite de courte durée (30 et des impulsions d'excursion utile de durée plus longue.

5. Détecteur suivant la revendication 4, caractérisé en ce que le circuit accroissant la raideur des flancs d'impulsions (5) est formé de plusieurs éléments différentiateurs connectés en circuit récurrent.

6. Détecteur suivant les revendication 1 à 5, caractérisé en ce que le circuit d'évaluation (2) est formé d'un discriminateur de niveau (7) à fonctionnement unipolaire et d'un circuit logique (4) et le discriminateur de niveau ne comprend qu'un seul seuil de niveau et ce souil de niveau est adéquatement réglé pour indiquer le dépassement d'une excursion de fréquence parasite positive et négative prédéfinie et le signal de sortie (23) du discriminateur de niveau est appliqué au circuit logique (4), à la sortie duquel la présence de la perturbation de réception est indiquée par un signal binaire (24)

7. Détecteur suivant la revendication 6, caractérisé en ce que le circuit d'évaluation contient a son entrée un circuit (5) accroissant la raideur des flancs d'impulsions et ce circuit convertit des impulsions d'entrée de polarité différente en impulsions de sortie de même polarité, et le signal ainsi déformé (31) est appliqué au discriminateur de niveau (7) suivi du circuit logique (4).

8. Détecteur suivant les revendications 6 et 7, caractérisé en ce que le circuit (5) accroissant la raideur des flancs d'impulsions est tel que la relation entre signal de sortie et signal d'entrée implique une fonction exponentielle (8) d'ordre pair ou une somme de telles fonctions exponentielles de même signe et l'exposant est supérieur à 1.

9. Détecteur suivant les revendications 6 à 8, caractérisé en ce que le circuit (5) accroissant la raideur des flancs d'impulsions comporte, pour la relation entre signal de sortie et signal d'entrée (31, 22), une fonction ayant le caractère d'une fonction cosinus hyperbolique (9).

10. Détecteur suivant les revendications 1 à 5, caractérisé en ce que le circuit d'évaluation (2) est constitué d'un discriminateur de niveau (3) à fonctionnement bipolaire et d'un circuit logique (4), et le discriminateur de niveau comprend un seuil de niveau positif (27) et un seuil de niveau négatif (28) et ces seuils de niveau sont adéquatement réglés pour indiquer le dépassement d'une excursion de fréquence parasite positive et négative prédéfinie, et le signal de sortie (23) du discriminateur de niveau est appliqué au circuit logique (4), à la sortie duquel la présence de la perturbation de réception est indiquée par un signal binaire (24).

11. Détecteur suivant les revendications 1 à 10, caractérisé en ce que le seuil de niveau du ou des discriminateurs de niveau est réglé adéquatement en fonction de l'amplitude moyenne dans le temps de la porteuse.

12. Détecteur suivant la revendication 11, caractérisé en ce que le seuil de niveau est augmenté à mesure que l'amplitude de la porteuse décroît.

13. Détecteur suivant les revendications 1 à 12, caractérisé en ce que le seuil de niveau du ou des discriminateurs de niveau est réglé dynamiquement en fonction de l'excursion de fréquence moyenne dans le temps.

**Claims**

1. Detector for indicating multipath reception disturbances by means of demodulation of the intermediate-frequency signal (21) in an ultrashort wave radio receiver that comprises a frequency demodulator (1) the output signal of this demodulator being applied to an evaluation circuit (2) at whose output the presence of a multipath reception disturbance is indicated by means of a logic signal, wherein the characteristic line (25) of the frequency demodulator is shaped such that the control range (26), in which the demodulator output signal (22) increases with an enhancing frequency deviation of the carrier frequency (intermediate-frequency signal (21)), is appreciably larger than the maximum frequency deviation of the intermediate-frequency carrier modulated with the baseband signal, and wherein the presence of a multipath reception disturbance is detected in the evaluation circuit and is indicated by means of a logic signal when the output signal of the demodulator transgresses a suitably preset frequency disturbance deviation threshold.

2. Detector as claimed in claim 1, wherein the evaluation circuit (2) includes a level discriminator (3) operating in a unipolar or bipolar mode and a logic circuit (4) has a level threshold which is suitably adjusted for indicating the transgression of a preset frequency disturbance deviation and wherein the output signal (23) of the level discriminator (3) is applied to the logic circuit (4) and the presence of the reception disturbance is indicated at the output of said logic circuit by means of a binary signal (24).

3. Detector a claimed in claim 2, wherein the evaluation circuit (2) comprises at its input a circuit (5) for increasing the steepness of the pulse flanks and whose processed output signal (29) is applied to the level discriminator (3) and the subsequent logic circuit (4).

4. Detector as claimed in claim 3, wherein the circuit (5) for increasing the steepness of the pulse flanks has a differentiating member (6) which includes a serial capacitor C and a parallel resistor R and has a time constant R*C adjusted so as to obtain a reliable separation of time-dependent short disturbance deviation pulses (30) from time-dependent longer useful deviation pulses.

5. Detector as claimed in claim 4, wherein the circuit (5) for increasing the steepness of the pulse flanks includes a plurality of differentiating members connected to one another in a chain.

6. Detector as claimed in claims 1 to 5, wherein the evaluation circuit (2) includes a unipolarly operating level discriminator (7) and includes a logic circuit (4) arranged so that the level discriminator has only one level threshold and this level threshold is suitably adjusted for indicating the transgression of preset positive and negative frequency disturbance deviations and an output signal (23) of the level discriminator is applied to the logic circuit (4) at whose output the presence of the reception disturbance is indicated by a binary signal (24).

7. Detector as claimed in claim 6, wherein the evaluation circuit has at its input a circuit (5) for increasing the steepness of the pulse flanks which converts input pulses having different polarities into output pulses having an identical polarity and wherein the signal (31) thus processed is applied to the level discriminator (7) with the logic circuit (4) connected to the latter.

8. Detector as claimed in claims 6 and 7, wherein the circuit (5) for increasing the steepness of the pulse flanks is formed so that the output signal is an even-numbered exponential function (8) of the input signal or is composed of a sum of such exponential functions with identical signs and the exponent is greater than the number 1.

9. Detector as claimed in claims 6 to 8, wherein said circuit (5) for increasing the steepness of the pulse flanks is formed so that the relation between the output and input signals (31, 32) is a function having the features of a hyperbola-cosine function (9).

10. Detector as claimed in claims 1 to 5, wherein said evaluation circuit (2) includes a bipolarly operating level discriminator (3) and a logic circuit (4) arranged so that the level discriminator has positive (27) and negative (28) level thresholds and these level thresholds are suitably adjusted for indicating the transgression of preset positive and negative frequency deviation, and wherein the output signal (23) of said level discriminator is applied to said logic circuit (4) at whose output the presence of the reception disturbance is indicated by a binary signal (24).

11. Detector as claimed in claims 1 to 10, wherein the level threshold of said level discriminator or level discriminators is appropriately adjusted in dependence on the time-averaged carrier amplitude.

12. Detector as claimed in claim 11, wherein the level threshold is increased according as the carrier amplitude is reduced.

13. Detector as claimed in claims 1 to 12 wherein the level threshold of the level discriminator(s) is dynamically adjusted in dependence on the time-averaged frequency deviation.

Fig. 1

Ausgangssignal

Frequenzhub

Fig. 2

Störhubpulse

positive Pegelschwelle

negative Pegelschwelle

Fig. 3

EP 0 132 752 B1

Fig. 4

Fig. 5

Fig. 6

Fig.7

Fig. 8

Fig. 9